Europäisches Patentamt

(19) European Patent Office

Office européen des brevets

(11) Numéro de publication : **0 278 534 B1**

(12) **FASCICULE DE BREVET EUROPEEN**

(45) Date de publication du fascicule du brevet :
**16.10.91 Bulletin 91/42**

(51) Int. Cl.$^5$ : **H03H 11/20**

(21) Numéro de dépôt : **88200005.2**

(22) Date de dépôt : **06.01.88**

(54) **Déphaseur large bande.**

(30) Priorité : **20.01.87 FR 8700566**

(43) Date de publication de la demande :
**17.08.88 Bulletin 88/33**

(45) Mention de la délivrance du brevet :
**16.10.91 Bulletin 91/42**

(84) Etats contractants désignés :
**DE FR GB IT**

(56) Documents cités :
**DE-B- 1 107 814
THE RADIO AND ELECTRONIC ENGINEER,
vol. 50, no. 3, mars 1980, pages 107-112, Institution of Electronic and Radio Engineers, Londres, GB ; S.R. AL-ARAJI et al. :
"Frequency-independent analogue phase-
shift network technique using field effect transistors"**

(73) Titulaire : **LABORATOIRES D'ELECTRONIQUE
PHILIPS
3, Avenue Descartes
F-94450 Limeil-Brévannes (FR)**
(84) Etats contractants désignés :
**FR**
Titulaire : **N.V. Philips' Gloeilampenfabrieken
Groenewoudseweg 1
NL-5621 BA Eindhoven (NL)**
(84) Etats contractants désignés :
**DE GB IT**

(72) Inventeur : **Dautriche, Pierre Société Civile
S.P.I.D.
209, rue de l'Université
F-75007 Paris (FR)**

(74) Mandataire : **Jacquard, Philippe et al
Société Civile S.P.I.D. 156, Boulevard
Haussmann
F-75008 Paris (FR)**

## Description

La présente invention a pour objet un déphaseur large bande comportant une première et une deuxième branche disposées en parallèle et recevant l'une et l'autre à leur entrée un même signal d'entrée et produisant à leur sortie respectivement un premier et un deuxième signal de sortie déphasés l'un par rapport à l'autre d'un angle donné, la première branche comportant un premier module déphaseur produisant un déphasage fonction d'un premier signal de commande, ledit signal de commande étant élaboré par une boucle de contre-réaction comprenant un détecteur sensible à la phase et recevant lesdits premier et deuxième signaux de sortie.

Un tel déphaseur est connu de l'article publié par AL-ARAJI et collaborateurs dans la revue "The Radio and Electronic Engineer" Vol. 50 n°3 p. 107-112 Mars 1980 et intitulé "Frequency. indépendent analogue phase-shift network technique using field effect transistors".

Cet article décrit un déphaseur pour basses fréquences, susceptible d'être utilisé dans la bande de fréquences 20-80 KHz pour produire un déphasage de 90° entre les deux sorties du déphaseur. La valeur désirée de la phase peut être choisie dans une plage de plus ou moins 20° autour de la valeur précitée de 90°.

Un tel déphaseur présente des inconvénients dûs notamment au fait que le déphasage entre les deux signaux de sortie est produit par un réseau déphaseur disposé dans une des deux branches alors que l'autre branche comporte un réseau résistif. Il en résulte que l'égalisation des amplitudes sur les deux sorties ne peut être obtenue avec précision sur une large gamme de fréquences.

L'idée de base de l'invention consiste à rendre symétrique la structure du déphaseur de manière à assurer une grande précision à la fois sur la phase et sur l'amplitude dans une large gamme de fréquences.

Le déphaseur selon l'invention est dans ce but caractérisé en ce que la deuxième branche comporte un deuxième module déphaseur produisant à sa sortie ledit deuxième signal de sortie et en ce que la boucle de contre-réaction comporte un circuit de commande recevant le signal de sortie dudit détecteur sensible à la phase et produisant ledit premier signal de commande ainsi qu'un deuxième signal de commande pour commander ledit deuxième module déphaseur, les deux signaux de commande étant générés de manière à produire des corrections de phase de sens opposés dans les deux modules déphaseurs.

Le détecteur sensible à la phase peut être un multiplieur. Le multiplieur peut être avantageusement un modulateur en anneau à transistors attaqué par chacun des signaux de sortie des déphaseurs et leur inverse.

Dans ce cas, ledit multiplieur peut comporter un premier et un deuxième déphaseur 0-180°, notamment comportant des amplificateurs différentiels MESFET à charge active, recevant a leur entrée respectivement le premier et le deuxième signal de sortie, de manière à produire les signaux de sortie du déphaseur et leurs inverses.

Lesdits amplificateurs différentiels comportent selon un mode de réalisation préféré un étage comportant un premier et un deuxième transistor MESFET couplés par les sources et dont les drains constituent une première et une deuxième sortie de l'amplificateur différentiel, ainsi qu'un troisième et un quatrième transistor MESFET dont la source et le drain sont connectés avec respectivement la source et le drain de respectivement le premier et le deuxième transistor et en ce que les première et deuxième sorties de l'amplificateur différentiel sont rétro-couplées à la grille respectivement des troisième et quatrième transistors à travers un premier et un deuxième condensateur de rétro-couplage.

La charge active peut être constitué par un cinquième et un sixième transistor MESFET dont la source est connectée au drain respectivement des premier et deuxième transistors, dont le drain est connecté à un pôle de tension d'alimentation et dont la source et la grille sont reliées entre elles à travers respectivement un troisième et un quatrième condensateur, et dont la grille est reliée audit pôle de tension d'alimentation à travers respectivement une première et une deuxième résistance.

Selon un mode de réalisation, le circuit de commande comporte un premier et un deuxième intégrateur, et le signal de sortie du détecteur sensible à la phase est un signal différentiel appliqué aux entrées du premier et du deuxième intégrateur. En tant que de besoin, au moins un desdits premier et deuxième intégrateur peut comporter une commande de décalage de niveau.

Un dit module déphaseur peut être tel que sa phase soit commandable entre 0 et 180°.

Un tel module déphaseur peut comporter un amplificateur différentiel d'entrée recevant un signal d'entrée et comportant une sortie inverseuse et une sortie non-inverseuse, et un premier et un deuxième étage de sortie du type push-pull réalisés avec des transistors MESFET, et comportant chacun une entrée inverseuse et une entrée non-inverseuse, ladite sortie inverseuse attaquant l'entrée inverseuse du premier étage de sortie ainsi que l'entrée non-inverseuse du deuxième étage de sortie, et ladite sortie non-inverseuse attaquant l'entrée non-inverseuse du premier étage de sortie ainsi que l'entrée inverseuse du deuxième étage de sortie, la sortie du premier étage de sortie étant chargée par le trajet drain-source d'un septième transistor MESFET, dont la grille reçoit un dit signal de commande, en série avec un cinquième condensateur, la sortie du deuxième étage de sortie étant chargée par une troisième et une quatrième résistance en série, et en ce que les tensions présentes

EP 0 278 534 B1

à la borne commune au trajet drain-source du septième transistor et au cinquième condensateur d'une part et à la borne commune aux troisième et quatrième résistances d'autre part, sont additionnées par un deuxième circuit sommateur dont la sortie est la sortie du module déphaseur.

Un tel montage présente l'avantage d'une tension de mode commun réduite.

L'invention sera mieux comprise à la lecture de la description qui va suivre en liaison avec les dessins qui représentent :

— la figure 1 un schéma d'un déphaseur selon l'art antérieur

— la figure 2 un schéma d'un déphaseur selon l'invention,

— les figures 3 et 4 respectivement un modulateur en anneau à transistors et un déphaseur 0-180° MOS constituant un multiplieur selon un mode de réalisation de l'invention,

— la figure 5, un mode de réalisation d'un circuit de commande selon l'invention,

— les figures 6a et 6b respectivement un schéma d'un module déphaseur selon l'invention et un mode de réalisation préféré de celui-ci.

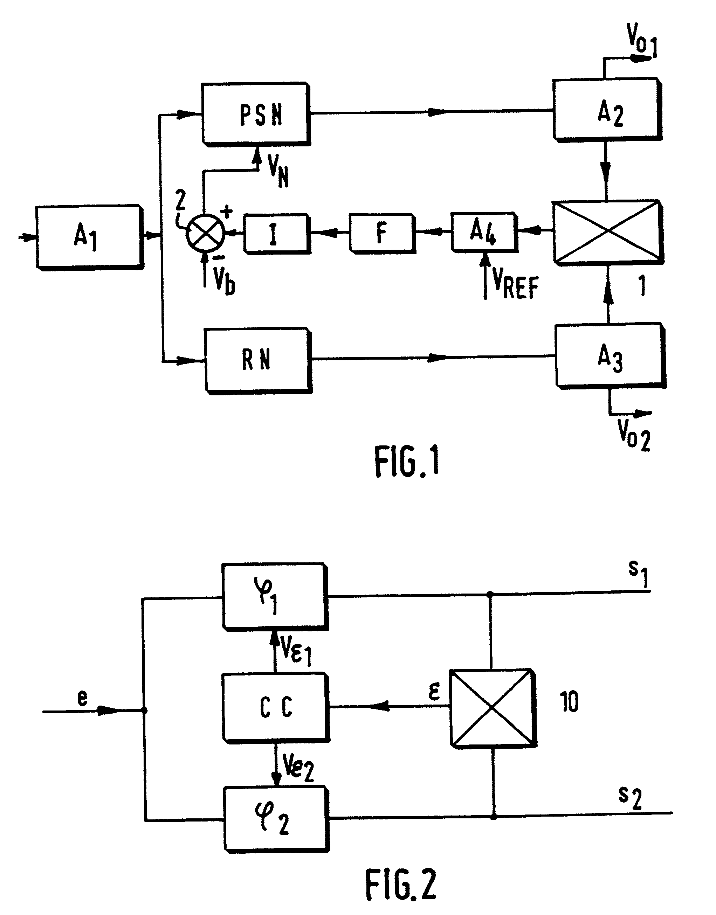

Selon la figure 1, un déphaseur de l'art antérieur (EL-ARAJI et collaborateurs) comporte un amplificateur tampon $A_1$, une première branche recevant le signal de sortie de l'amplificateur $A_1$ et comportant successivement un module déphaseur constitué par un réseau à déphasage commandable PSN et un amplificateur de sortie $A_2$, une deuxième branche recevant le signal de sortie de l'amplificateur $A_1$ comportant successivement un réseau résistif RN, de gain sensiblement identique à celui du réseau à déphasage commandable PSN, et un amplificateur de sortie $A_3$. La commande de la phase du réseau PSN est obtenue par une boucle de contre-réaction comportant un détecteur sensible à la phase recevant les signaux de sortie $Vo_1$ et $Vo_2$ des amplificateurs de sortie respectivement $A_2$ et $A_3$, et dont la sortie attaque un amplificateur $A_4$ qui reçoit une tension $V_{REF}$ de réglage de décalage de zéro, et qui est disposé en cascade avec successivement un filtre F et un intégrateur I. La différence entre le signal de sortie de l'intégrateur I et une tension de consigne $V_b$ est effectuée par un comparateur 2 et constitue la tension $V_N$ qui commande le déphasage produit par le réseau PSN. Cette tension est appliquée à la porte d'un transistor à effet de champ de manière à faire varier sa résistance drain-source et donc la phase d'un réseau RC dans lequel il est incorporé. La présence du réseau résistif dans la deuxième branche a pour objet d'obtenir une atténuation du gain aussi voisine que possible de celle produite par le réseau PSN, de manière que les deux signaux de sortie $Vo_1$ et $Vo_2$ aient dans la mesure du possible la même amplitude. Une telle égalisation d'amplitude ne peut être obtenue avec précision que pour une fréquence donnée. Sur une large bande de fréquences, le réseau PSN ne présente en effet pas une atténuation constante.

Selon la figure 2 correspondant à un déphaseur selon l'invention, les première et deuxième branches comportent chacune un module déphaseur respectivement $\varphi_1$ et $\varphi_2$ commandé chacun par un signal de commande respectivement $V\varepsilon_1$ et $V\varepsilon_2$. Les signaux de commande sont générés par une boucle de contre-réaction comprenant un détecteur sensible à la phase et un circuit de commande CC. Le détecteur sensible à la phase est ici un multiplieur 10 recevant à ses entrées les sorties $s_1$ et $s_2$ des modules déphaseurs $\varphi_1$ et $\varphi_2$, lesquelles constituent les sorties du déphaseur. Ce montage est de préférence réalisé de manière à charger les sorties $s_1$ et $s_2$ par les mêmes impédances, ce qui permet d'obtenir une plus grande précision. Le signal de sortie du multiplieur 10 est un signal $\varepsilon$ qui attaque un circuit de commande destiné à générer les signaux de commande $V\varepsilon_1$ et $V\varepsilon_2$ dans des conditions telles que les correc tions de phase produites par la boucle de contre-réaction soient de sens opposés dans les deux modules déphaseurs. Supposons par exemple que les modules déphaseurs $\varphi_1$ et $\varphi_2$ soient commandables chacun de manière à produire des déphasages entre 0 et 180°, les corrections de phase produites par les signaux $V\varepsilon_1$ et $V\varepsilon_2$ pourront être de sens opposés par rapport à une valeur centrale de déphasage de 90° pour une fréquence donnée choisie par exemple en milieu de bande. En d'autres termes, lorsque le déphaseur est calé en phase (c'est-à-dire $\pounds = \cos\varphi = 0$ soit $\varphi = 90°$), le signal $s_1$ présente par rapport au signal d'entrée e un retard de 90° moins 45° (correction de phase) soit 45° et le signal $s_2$, un retard de 90° plus 45° (correction de phase de sens opposé), soit 135°, ce qui correspond à un déphasage de 90° entre les sorties $s_1$ et $s_2$.

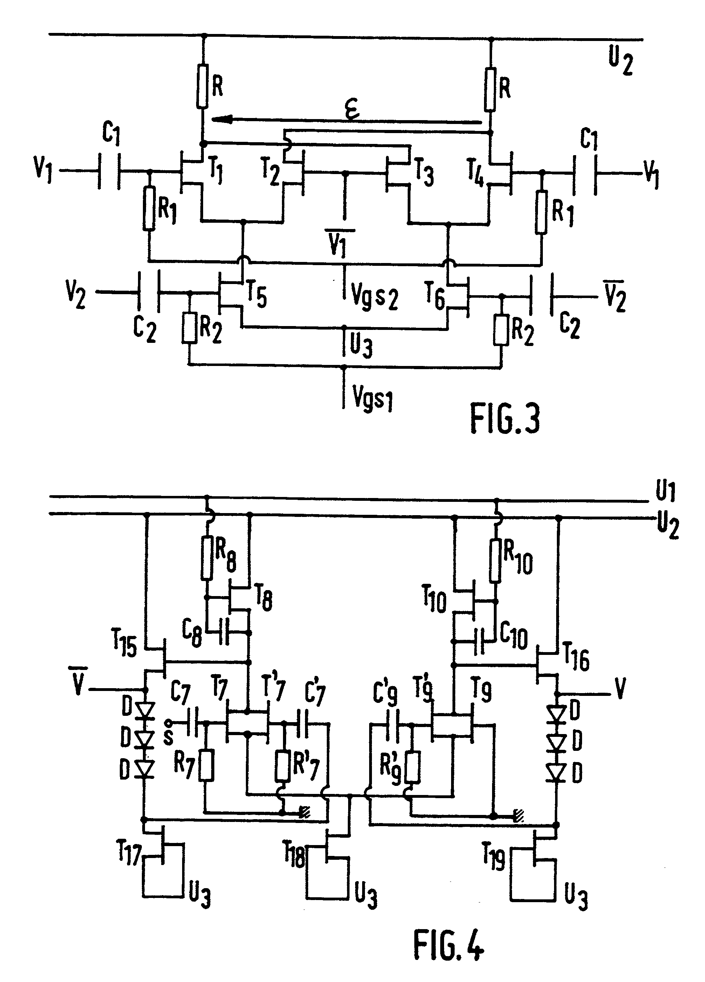

Les figures 3 et 4 illustrent un mode de réalisation du multiplieur 10 mettant en oeuvre un montage du type dit "modulateur en anneau à transistors". Le multiplieur proprement dit est représenté à la figure 3. Il comporte un premier étage comprenant deux étages différentiels comportant chacun deux transistors MESFET, respectivement $(T_1, T_2)$ et $(T_3, T_4)$ couplés par les sources. Les grilles des transistors $T_2$ et $T_3$ sont connectées entre elles. Les drains des transistors $T_1$ et $T_3$ sont connectés entre eux et reliés à une source de tension d'alimentation $U_2$ (par exemple de 6 V) à travers une résistance R. Les drains des transistors $T_2$ et $T_4$ sont connectés entre eux et reliés à la source de tension $U_0$ à travers une résistance R. Les grilles des transistors $T_1$ et $T_4$ sont reliés à un pôle de tension d'alimentation $Vgs_2$ (par exemple – 2 V) à travers une résistance $R_1$. Les grilles des transistors $T_1$ et $T_4$ reçoivent un signal $V_1$ à travers un condensateur $C_1$, et les grilles des transistors $T_2$ et $T_3$ reçoivent l'inverse $\overline{V}_1$ dudit signal. Le deuxième étage comporte un seul étage différentiel constitué par des transistors MESFET $T_5$ et $T_6$ couplés par les sources celles-ci étant connectées à une source de tension $U_3$

3

EP 0 278 534 B1

(par exemple – 4 V), le drain du transistor $T_5$ étant connecté aux sources des transistors $T_1$ et $T_2$, et le drain du transistor $T_8$ étant connecté aux sources des transistors $T_3$ et $T_4$. Les grilles des transistors $T_5$ et $T_6$ sont reliées à un pôle de tension d'alimentation $Vgs_1$ (par exemple – 5,5 V) chacune à travers une résistance $R_2$. La grille du transistor $T_5$ reçoit un signal $V_2$ à travers un condensateur $C_2$, et celle du transistor $T_6$ reçoit l'inverse $\overline{V}_2$ dudit signal à travers un condensateur $C_2$. Le signal $\varepsilon$ de sortie du multiplieur 10 est disponible sous forme différentielle entre les drains des transistors $T_1$ et $T_4$.

Les signaux $V_1$, $\overline{V}_1$, et $V_2$, $\overline{V}_2$ sont produits par des déphaseurs 0-180°, par exemple des amplificateurs différentiels dont un mode préféré de réalisation est donné à la figure 4, et présentant des charges actives. Il comporte un étage différentiel comprenant deux transistors MESFET $T_7$ et $T_9$ couplés par les sources et dont les drains sont chargés par des transistors $T_8$ et $T_{10}$ formant lesdites charges actives. Pour ce faire, les sources des transistors $T_8$ et $T_{10}$ sont connectées aux drains respectivement des transistors $T_7$ et $T_9$, la grille et la source de chacun des transistors $T_8$ et $T_{10}$ sont reliées entre elles à travers un condensateur respectivement $C_8$ et $C_{10}$, la grille des transistors $T_8$ et $T_{10}$ est reliée à un pôle de tension d'alimentation $U_1$ (par exemple 1,5 V) à travers une résistance de polarisation respectivement $R_8$ et $R_{10}$, et les drains des transistors $T_8$ et $T_{10}$ sont connectés à un deuxième pôle de tension d'alimentation $U_2$ (par exemple 6 V).

La mise en oeuvre d'une telle charge active permet d'obtenir un gain relativement élevé en hautes fréquences où les condensateurs $C_8$ et $C_{10}$ équivalent à des court-circuits tout en conservant un gain de l'ordre de l'unité en continu (pour des transistors de même géométrie). Les sorties V et $\overline{V}$ de l'amplificateur différentiel sont les sources de deux transistors $T_{15}$ et $T_{16}$ montées en source suiveuse sur les drains des transistors $T_7$ et $T_9$. Un transistor $T_{18}$ dont la source et la porte sont connectées entre elles et à un pôle de tension d'alimentation $U_3$ (par exemple – 4 V) et dont le drain est connecté aux sources des transistors $T_7$ et $T_9$ constitue la source de courant de l'étage différentiel $T_7$, $T_9$. Un signal d'entrée s est appliqué à la grille du transistor $T_7$ reliée au pôle de mode commun (masse) à travers une résistance $R_7$. La grille de $T_9$ est connectée à la masse. Un fonctionnement optimisé de l'amplificateur différentiel peut être obtenu en adjoignant à chacun des transistors $T_7$ et $T_9$ un transistor de plus petites dimensions respectivement $T'_7$ et $T'_9$ dont la source et le drain sont respectivement interconnectés avec la source et le drain respectivement des transistors $T_7$ et $T_9$. La grille des transistors $T_7$, $T'_7$ et $T'_9$ sont reliées au pôle de mode commun (masse) à travers respectivement des résistances $R_7$, $R'_7$ et $R'_9$ alors que la grille du transistor $T_9$ est connectée directement au pôle de mode commun. La grille des transistors $T'_7$ et $T'_9$ reçoit un signal de contre-réaction à partir des sorties de l'amplificateur, à savoir la source respectivement des transistors $T_{15}$ et $T_{16}$. A cet effet, une pluralité de diodes de décalage de niveau, ici au nombre de 3, sont disposées en série dans le sens direct avec la source des transistors respectivement $T_{15}$ et $T_{16}$ et avec un transistor respectivement $T_{17}$ et $T_{19}$ monté en source de courant de la même manière que le transistor $T_{18}$. La contre-réaction est obtenue en reliant le drain des transistors $T_{17}$ et $T_{19}$ respectivement à la grille des transistors $T'_7$ et $T'_9$ à travers un condensateur de découplage respectivement $C'_7$ et $C'_9$. Le passage d'un courant déterminé dans les diodes montées en série assure une chute de tension précise dans les diodes montées en série et une compensation de niveau précise pour la contre-réaction.

Le déphaseur 0-180° comporte une entrée sur la porte du transistor $T_7$, de préférence à travers un condensateur $C_7$ et recevant le signal s qui est l'un des signaux $s_1$ ou $s_2$ pour produire en sortie sur les sources des transistors $T_{15}$ et $T_{16}$, dans le premier cas respectivement les signaux $V_1$ et $\overline{V}_1$ et dans le deuxième cas respectivement les signaux $V_2$ et $\overline{V}_2$.

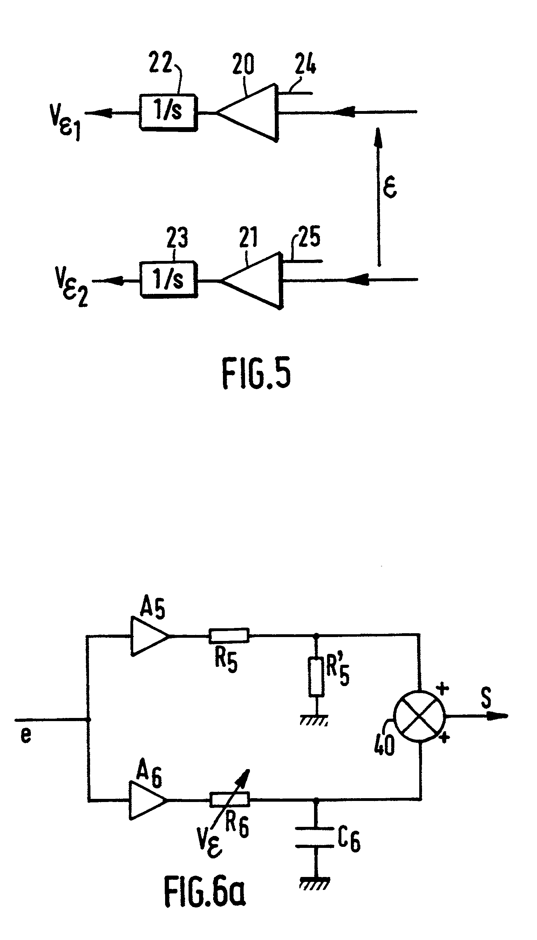

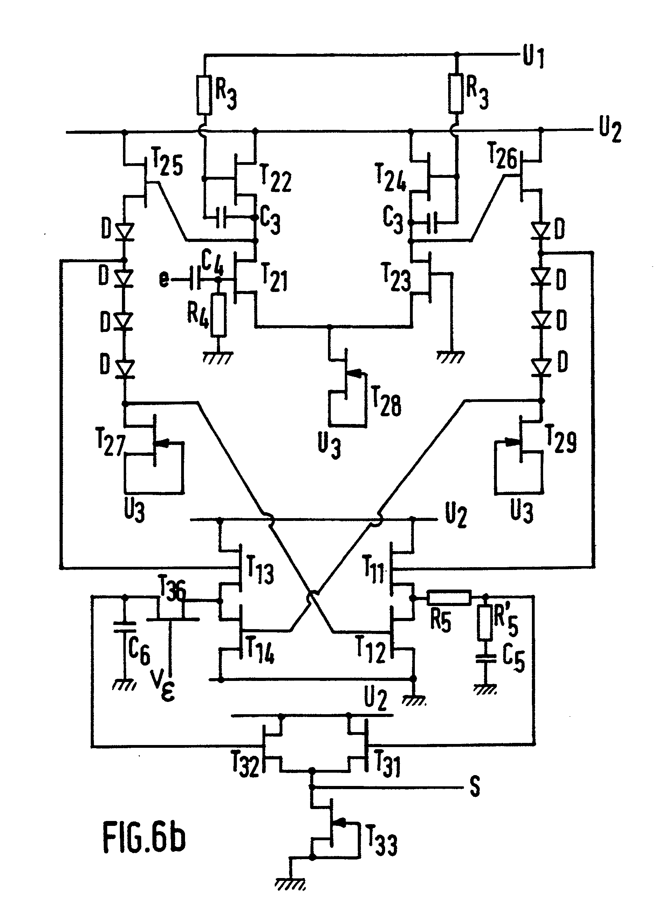

Selon la figure 5, le circuit de commande cc comporte deux amplificateurs 20 et 21 associés à des intégrateurs respectivement 22 et 23. Les amplificateurs 20 et 21 peuvent présenter chacun en tant que de besoin une entrée respectivement 24 et 25 destinée à produire le décalage de niveau des signaux $V_{\varepsilon 1}$ et $V_{\varepsilon 2}$. Il convient toutefois de remarquer que pour les valeurs données à titre d'exemple dans la description de la figure 3 et pour une tension de pincement $V_p$ des transistors égale à – 2,5 V, le signal $\varepsilon$ présente directement un décalage de niveau compatible avec le circuit qui va être décrit en liaison avec la figure 6b, avec les mêmes valeurs des tensions $U_1$, $U_2$ et $U_3$ toujours données à titre d'exemple.

Selon la figure 6a, un module déphaseur ($\varphi_1$, $\varphi_2$) comporte deux branches en parallèle recevant le signal d'entrée e. La première branche parallèle comporte un amplificateur $A_5$ dont la sortie est chargée par deux résistances de même valeur en série $R_5$ et $R'_5$, $R'_5$ ayant une borne connectée au pôle de mode commun. La borne commune aux résistances $R_5$ et $R'_5$ constitue la sortie de la première branche. La deuxième branche parallèle comporte un amplificateur inverseur $A_6$ dont la sortie est chargée par une résistance variable $R_6$ dont la valeur est commandée par une tension V$\varepsilon$ et un condensateur $C_6$ dont une borne est connectée au pôle de mode commun. La borne commune à la résistance $R_6$ et au condensateur $C_6$ constitue la sortie de la deuxième branche. La tension V$\varepsilon$ est égale à V$\varepsilon_1$ pour le module $\varphi_1$ et à V$\varepsilon_2$ pour le module $\varphi_2$.

Les sorties des deux branches sont additionnées par un sommateur 40 dont la sortie fournit un signal S qui est le signal $s_1$ pour le module $\varphi_1$ et le signal $s_2$ pour le module $\varphi_2$.

On a alors avec $R_5 = R'_5$ et les deux amplificateurs $A_5$ et $A_6$ ayant le même gain A :

4

$$S = \frac{AVe}{2} - \frac{AVe}{jC_6\omega} \quad \frac{1}{R_6 + \dfrac{1}{jC_6\omega}}$$

soit :
$$S = \frac{-AVe}{2} \quad \frac{1 - \tau p}{1 + \tau p}$$

Le déphasage pour une fréquence donnée dépend de la constante de temps $\tau = R_6 C_6$.
On a :

$$|\frac{S}{e}| = \frac{A}{2} \quad \Delta\varphi = 180° - 2 \text{ Arc tg } p\tau$$

On peut ainsi décrire un écart de phase $\Delta\varphi$ variant de 0 à 180° suivant la valeur de $\tau$, donc de R.

La figure 6b décrit un mode de réalisation particulièrement avantageux du déphaseur 0-180°, mettant en oeuvre un étage différentiel d'entrée à transistors MESFET à charge active, et un étage de sortie pour chaque amplificateur, mettant en oeuvre des transistors MESFET montés en push-pull, ce qui permet d'optimiser la tension résiduelle de mode commun.

On obtient donc une amélioration en ce qui concerne la phase jusqu'à la fréquence de coupure du transistor.

Selon la figure 6b, le déphaseur comporte un étage différentiel d'entrée comprenant deux transistors MOS $T_{21}$ et $T_{23}$ dont les sources sont couplées et connectées à une source de courant constituée par un transistor $T_{28}$ dont la grille et la source sont connectées au pôle de tension d'alimentation $U_3$ (par exemple – 4 V), et le drain connecté aux sources des transistors $T_{21}$ et $T_{23}$ précités. La tension d'entrée e est appliquée à la porte du transistor $T_{21}$ à travers un réseau de découplage comportant un condensateur série $C_4$ et une résistance $R_4$ disposée en parallèle entre la grille du transistor $T_{21}$ et le pôle de mode commun. La grille du transistor $T_{23}$ est directement référencée au pôle de mode commun.

Afin d'améliorer la réponse de l'étage, les drains de transistors $T_{21}$ et $T_{23}$ sont associés à une charge active constituée par un transistor MESFET respectivement $T_{22}$ et $T_{24}$ dont la source est connectée au drain du transistor correspondant, et comportant un condensateur $C_3$ de faible valeur (de l'ordre du picofarad) connecté entre leur source et leur grille. La grille de chacun des transistors $T_{22}$ et $T_{24}$ est reliée à un pôle de tension d'alimentation $U_1$ (par exemple + 1,5 V) à travers une résistance $R_3$, alors que leur drain est connecté à un pôle de tension d'alimentation $U_2$ (par exemple + 6 V).

Des transistors $T_{25}$ et $T_{26}$ montés en suiveur et dont le drain est directement référencé à la source de tension $U_2$ reçoivent sur leur porte les tensions de drain respectivement des transistors $T_{21}$ et $T_{23}$. Les sources des transistors $T_{25}$ et $T_{26}$ sont connectés chacun à un groupe de plusieurs diodes D en série, dans cet exemple au nombre de 4, de manière à réaliser une adaptation de niveau pour les étages push-pull de sortie. Des transistors $T_{27}$ et $T_{29}$ montés en source de courant de manière analogue au transistor $T_{28}$ ont leur drain connecté à la cathode de la dernière diode de chaque groupe, de manière à définir le courant traversant les diodes et donc la chute de tension dans celles-ci.

La source des transistors $T_{25}$ et $T_{26}$ est reliée à la grille respectivement des transistors $T_{13}$ et $T_{11}$ avec une chute de tension dans une diode et à la grille respectivement des transistors $T_{12}$ et $T_{14}$ avec une chute de tension dans les quatre diodes.

Les résistances $R_5$ et $R'_5$ sont raccordées en série entre la sortie de l'étage push-pull $T_{11}$, $T_{12}$ et le pôle de mode commun avec interposition d'un condensateur de découplage $C_5$ de l'ordre du nF. La résistance variable $R_6$ est la résistance drain-source d'un transistor MESFET $T_{36}$ dont le drain est connecté à la sortie de l'étage push-pull $T_{13}$, $T_{14}$ et dont la source est connectée à la borne non à la masse du condensateur $C_6$.

Enfin, le sommateur 40 est constitué par deux transistors MESFET $T_{31}$ et $T_{32}$ dont les drains sont connectés à la source de tension d'alimentation $U_2$, dont les sources sont couplées entre elles et connectées à transistor $T_{33}$ monté en source de courant de manière analogue au transistor $T_{28}$. La source du transistor $T_{36}$ est connectée à la porte du transistor $T_{32}$ et la borne commune aux résistances $R_5$ et $R'_5$, à la porte du transistor $T_{31}$, ce qui fait que la somme S de leurs tensions apparaît sur les sources des transistors $T_{31}$ et $T_{32}$. Pour faire varier l'écart de phase entre 0 et 180°, il faut faire varier la tension $V\varepsilon$ jusqu'à la tension de pincement du canal du transistor $T_{36}$. Avec les valeurs des tensions $U_1$, $U_2$, $U_3$, $Vgs_1$ et $Vgs_2$ précités, lorsque l'écart de phase entre les sorties $s_1$ et $s_2$ est de 90°, les signaux qui attaquent les entrées des amplificateurs 20 et 21 sont tous les deux au niveau + 4 V, ce qui est compatible, pour les amplificateurs 20 et 21 ayant un gain unitaire avec la commande de la grille du transistor $T_{36}$.

L'invention ne se limite pas au mode de réalisation décrit et représenté. Par exemple d'autres montages que ceux mettant en oeuvre des transistors MESFET peuvent être utilisés. En outre, le détecteur sensible à la phase peut être un multiplieur double équilibré connu en soi.

## Revendications

1. Déphaseur large bande comportant une première et une deuxième branche disposées en parallèle et recevant l'une et l'autre à leur entrée un même signal d'entrée (e) et produisant à leur sortie respectivement un premier ($S_1$) et un deuxième ($S_2$) signal de sortie déphasés l'un par rapport à l'autre d'un angle donné, la première branche comportant un premier module déphaseur ($\varphi_1$) produisant un déphasage fonction d'un premier signal de commande ($V_{\varepsilon 1}$), ledit signal de commande étant élaboré par une boucle de contre-réaction comprenant un détecteur (10) sensible à la phase et recevant lesdits premier et deuxième signaux de sortie, caractérisé en ce que la deuxième branche comporte un deuxième module déphaseur ($\varphi_2$) produisant à sa sortie ledit deuxième signal de sortie et en ce que la boucle de contre-réaction comporte un circuit de commande (CC) recevant le signal de sortie dudit détecteur sensible à la phase et produisant ledit premier signal de commande ainsi qu'un deuxième signal de commande ($V_{\varepsilon 2}$) pour commander ledit deuxième module déphaseur, les deux signaux de commande étant générés de manière à produire des corrections de phase de sens opposés dans les deux modules déphaseurs.

2. Déphaseur selon la revendication 1, caractérisé en ce que le détecteur sensible à la phase est un multiplieur.

3. Déphaseur selon la revendication 2 caractérisé en ce que le multiplieur est un modulateur en anneau à transistors attaqué par chacun des signaux de sortie des déphaseurs et leur inverse.

4. Déphaseur selon la revendication 3, caractérisé en ce qu'il comporte un premier et un deuxième déphaseur 0-180° recevant a leur entrée respectivement le premier et le deuxième signal de sortie, de manière à produire les signaux de sortie du déphaseur et leurs inverses.

5. Déphaseur selon la revendication 4, caractérisé en ce que les déphaseurs 0-180° sont des amplificateurs différentiels MESFET à charge active.

6. Déphaseur selon la revendication 5, caractérisé en ce que lesdits amplificateurs différentiels comportent un étage comportant un premier et un deuxième transistor MESFET couplés par les sources et dont les drains constituent une première et une deuxième sortie de l'amplificateur différentiel, ainsi qu'un troisième et un quatrième transistor MOS dont la source et le drain sont connectés avec respectivement la source et le drain de respectivement le premier et le deuxième transistor et en ce que les première et deuxième sorties de l'amplificateur différentiel sont rétro-couplées à la grille respectivement des troisième et quatrième transistor à travers un premier et un deuxième condensateur de rétro-couplage.

7. Déphaseur selon une des revendications 5 ou 6 caractérisé en ce que la charge active est constituée par un cinquième et un sixième transistor MESFET dont la source est connectée au drain respectivement des premier et deuxième transistors, dont le drain est connecté à un pôle de tension d'alimentation et dont la source et la grille sont reliées à travers respectivement un troisième et un quatrième condensateur, et dont la porte est reliée audit pôle de tension d'alimentation à travers une première et une deuxième résistance.

8. Déphaseur selon une des revendications précédentes caractérisé en ce que le circuit de commande comporte un premier et un deuxième intégrateur et en ce que le signal de sortie du détecteur sensible à la phase est un signal différentiel appliqué aux entrées du premier et du deuxième intégrateur.

9. Déphaseur selon la revendication 8 caractérisé en ce qu'au moins un desdits premier et deuxième intégrateur comporte une correction de décalage de niveau.

10. Déphaseur selon une des revendications précédentes caractérisé en ce qu'un module déphaseur est tel que sa phase est commandable entre 0 et 180°.

11. Déphaseur selon la revendication 10 caractérisé en ce qu'il comporte un amplificateur différentiel d'entrée recevant un signal d'entrée et comportant une sortie inverseuse et une sortie non-inverseuse, et un premier et un deuxième étage de sortie du type push-pull réalisés avec des transistors MESFET, et comportant chacun une entrée inverseuse et une entrée non-inverseuse, ladite sortie inverseuse attaquant l'entrée inverseuse du premier étage de sortie et l'entrée non-inverseuse du deuxième étage de sortie, et ladite sortie non-inverseuse attaquant l'entrée non-inverseuse du premier étage de sortie et l'entrée inverseuse du deuxième étage de sortie, la sortie du deuxième étage de sortie étant chargée par le trajet drain-source d'un septième transistor dont la grille reçoit un dit signal de commande en série avec un cinquième condensateur, la sortie du premier étage de sortie étant chargée par une troisième et une quatrième résistance en série, et en ce que les tensions présentes à la borne commune au trajet drain-source du septième transistor et au cinquième condensateur d'une part et à la borne commune aux troisième et quatrième résistance d'autre part, sont additionnées par un deuxième circuit sommateur dont la sortie est la sortie du module déphaseur.

**Patentansprüche**

1. Breitbandphasenschieber mit einem ersten und einem zweiten zueinander parallelgeschalteten Zweig, die je an ihrem Eingang dasselbe Eingangssignal (e) erhalten und an ihrem jeweiligen Ausgang ein erstes (S1) und ein zweites (S2) zueinander um einen bestimmten Winkel phasenverschobenes Ausgangssignal liefern, wobei der erste Zweig einen ersten Phasenschiebermodul ($\phi$1) aufweist, der in Funktion eines ersten Steuersignals (V$\epsilon$1) eine Phasenverschiebung erzeugt, wobei dieses Steuersignal von einer negativen Rückkopplungsschleife mit einem phasenempfindlichen Detektor (10) erzeugt wird, wobei diese Rückkopplungsschleife die genannten ersten und zweiten Ausgangssignale erhält, dadurch gekennzeichnet, daß der zweite Zweig einen zweiten, an seinem Ausgang das zweite Ausgangssignal liefernden Phasenschiebermodul ($\phi$2) aufweist, und daß die negative Rückkopplungsschleife eine Steuerschaltung (CC) aufweist, die das Ausgangssignal des phasenempfindlichen Detektors erhält und das genannte erste Steuersignal erzeugt, ebenso wie ein zweites Steuersignal V$\epsilon$2) zur Steuerung des zweiten Phasenschiebermoduls, wobei die zwei Steuersignale derart erzeugt werden, daß in den beiden Phasenschiebermodulen entgegengesetzt gerichtete Phasenkorrekturen herbeigeführt werden.

2. Phasenschieber nach Anspruch 1, dadurch gekennzeichnet, daß der phasenempfindliche Detektor ein Multiplizierer ist.

3. Phasenschieber nach Anspruch 2, dadurch gekennzeichnet, daß der Multiplizierer ein Transistor-Ringmodulator ist, der von jedem der Phasenschieber-Ausgangssignale und ihren invertierten Werten betrieben wird.

4. Phasenschieber nach Anspruch 3, dadurch gekennzeichnet, daß er einen ersten und einen zweiten 0-180°-Phasenschieber aufweist, die an ihrem jeweiligen Eingang das erste bzw. zweite Ausgangssignal erhalten, und zwar derart, daß die Ausgangssignale des Phasenschiebers und ihre invertierten Werte erzeugt werden.

5. Phasenschieber nach Anspruch 4, dadurch gekennzeichnet, daß die 0-180°-Phasenschieber MESFET-Differentialverstärker mit aktiver Belastung sind.

6. Phasenschieber nach Anspruch 5, dadurch gekennzeichnet, daß die genannten Differentialverstärker eine Stufe mit einem ersten und einem zweiten Source-gekoppelten MESFET-Transistor aufweisen, wobei die Drain-Elektroden einen ersten und einen zweiten Ausgang der Differentialverstärker bilden, sowie mit einem dritten und einem vierten MOS-Transistor, wobei die Source- und die Drain-Elektroden mit den Source- bzw. Drain-Elektroden des ersten bzw. zweiten Transistors gekoppelt sind, und daß der erste und zweite Ausgang des Differentialverstärkers über einen ersten bzw. zweiten Rückkopplungskondensator mit der Gate-Elektrode des dritten bzw. vierten Transistors zurückgekoppelt sind.

7. Phasenschieber nach Anspruch 5 oder 6, dadurch gekennzeichnet, daß die live Belastung durch einen fünften und sechsten MESFET-Transistor gebildet ist, dessen Source-Elektrode mit der Drain-Elektrode des ersten bzw. zweiten Transistors verbunden ist, dessen Drain-Elektrode mit einem Speisespannungspol verbunden ist und dessen Source- und Gate-Elektrode über einen dritten bzw. vierten Kondensator miteinander verbunden sind und dessen Gate-Elektrode über einen ersten und einen zweiten Widerstand mit dem genannten Speisespannungspol verbunden ist.

8. Phasenschieber nach einem der vorstehenden Ansprüche, dadurch gekennzeichnet, daß die Steuerschaltung einen ersten und einen zweiten Integrator aufweist und daß das Ausgangssignal des phasenempfindlichen Detektors ein den Eingängen des ersten und zweiten Integrators zugeführtes Differenzsignal ist.

9. Phasenschieber nach Anspruch 8, dadurch gekennzeichnet, daß mindestens einer der genannten ersten und zweiten Integratoren eine Pegelverschiebungskorrekturschaltung aufweist.

10. Phasenschieber nach einem der vorstehenden Ansprüche, dadurch gekennzeichnet, daß ein Phasenschiebermodul derart ausgebildet ist, daß die Phase zwischen 0 und 180° regelbar ist.

11. Phasenschieber nach Anspruch 10, dadurch gekennzeichnet, daß er einen ein Eingangssignal erhaltenden Eingangs-Differentialverstärker mit einem invertierenden und einem nicht-invertierenden Ausgang hat, sowie eine erste und eine zweite Gegentakt-Ausgangsstufe mit MESFET-Transistoren, die je einen invertierenden und einen nicht-invertierenden Eingang aufweisen, wobei der genannte invertierende Ausgang den invertierenden Eingang der ersten Ausgangsstufe sowie den nicht-invertierenden Eingang der zweiten Ausgangsstufe betreibt, wobei der genannte nicht-invertierende Ausgang den nicht-invertierenden Eingang der ersten Ausgangsstufe und den invertierenden Eingang der zweiten Ausgangsstufe betreibt, wobei der Ausgang der zweiten Ausgangsstufe durch die Drain-Source-Strecke eines siebten Transistors belastet wird, dessen Gate-Elektrode in Reihe mit einem fünften Kondensator ein genanntes Steuersignal erhält, wobei der Ausgang der ersten Ausgangsstufe durch einen dritten und einen vierten Reihenwiderstand belastet ist, und daß die an der gemeinsamen Klemme in der Drain-Source-Strecke des siebten Transistors und an dem fünften Kondensator einerseits und an der gemeinsamen Klemme des dritten und vierten Widerstandes andererseits vorhandenen Spannungen durch eine zweite Summierungsschaltung addiert werden, deren Ausgang der Ausgang des Phasenschiebermoduls ist.

## Claims

1. A wide-band phase shifter comprising a first and a second branch arranged in parallel and receiving the same input signal (e) at their inputs and producing a first ($S_1$) and a second ($S_2$) output signal at their outputs, which signals are phase-shifted with respect to each other by a given angle, the first branch comprising a first phase shift module ($\varphi_1$) producing a phase shift as a function of a first control signal ($V\varepsilon_1$), said control signal being processed by a negative feedback loop comprising a phase-sensitive detector (10) and receiving said first and second output signals, characterized in that the second branch comprises a second phase shift module ($\varphi_2$) producing said second output signal at its output and in that the negative feedback loop comprises a control circuit (CC) receiving the output signal of said phase-sensitive detector and producing said first control signal as well as a second control signal ($V_{\varepsilon 2}$) for controlling said second phase shift module, the two control signals being generated so as to produce oppositely directed phase corrections in the two phase shift modules.

2. A phase shifter as claimed in Claim 1, characterized in that the phase-sensitive detector is a multiplier.

3. A phase shifter as claimed in Claim 2, characterized in that the multiplier is a transistor ring modulator receiving each of the output signals of the phase shifters and their inverse values.

4. A phase shifter as claimed in Claim 3, characterized in that it comprises a first and a second 0-180° phase shifter receiving the first and the second output signal at their input so as to produce the output signals of the phase shifter and their inverse values.

5. A phase shifter as claimed in Claim 4, characterized in that the 0-180° phase shifters are MESFET differential amplifiers having an active charge.

6. A phase shifter as claimed in Claim 5, characterized in that said differential amplifiers comprise a stage including a first and a second MESFET transistor which are source-coupled and whose drains constitute a first and a second output of the differential amplifier, as well as a thud and a fourth MOS transistor whose source and drain are connected to the source and the drain of the first and the second transistor, respectively, and in that the first and second outputs of the differential amplifier are fed back to the gates of the thud and fourth transistors, respectively, via a first and a second feedback capacitor.

7. A phase shifter as claimed in any one of Claim 5 or 6, characterized in that the active charge comprises a fifth and a sixth MESFET transistor whose source is connected to the drain of the first and second transistors, respectively, whose drain is connected to a power supply terminal and whose source and gate are connected via a thud and a fourth capacitor, respectively, and whose gate is connected to said power supply terminal via a first and a second resistor.

8. A phase shifter as claimed in any one of the preceding Claims, characterized in that the control circuit comprises a first and a second integrator and in that the output signal of the phase-sensitive detector is a differential signal applied to the inputs of the first and the second integrator.

9. A phase shifter as claimed in Claim 8, characterized in that at least one of said first and second integrators comprises a circuit for level shift correction.

10. A phase shifter as claimed in any one of the preceding Claims, characterized in that the phase shift of a phase shift module can be controlled between 0 and 180°.

11. A phase shifter as claimed in Claim 10, characterized in that it comprises a differential input amplifier receiving an input signal and having an inverting output and a non-inverting output and a first and a second output stage of the push-pull type realised with MESFET transistors each comprising an inverting input and a non-inverting input, said inverting output controlling the inverting input of the first output stage and the non-inverting input of the second output stage and said non-inverting output controlling the non-inverting input of the first output stage and the inverting input of the second output stage, the output of the second output stage being charged by the drain-source path of a seventh transistor whose gate receives a control signal in series with a fifth capacitor, the output of the first output stage being charged by a third and a fourth resistor arranged in series, and in that the voltages present at the common terminal of the drain-source path of the seventh transistor and the fifth capacitor and at the common terminal of the third and fourth resistors are added by a second summation circuit whose output is the output of the phase shift module.

FIG.1

FIG.2

FIG.3

FIG.4

FIG.5

FIG.6a

FIG.6b